# EUROPEAN PATENT SPECIFICATION

(11) **EP 0 151 694 B1**
(45) Date of publication and mention of the grant of the patent: **03.02.1993**
(21) Application number: 84112567.7
(22) Date of filing: 18.10.1984
(51) Int. Cl.: G01R 31/318

(54) **Logic circuit with built-in self-test function**
Logische Schaltung mit eingebauter Selbsttestfunktion
Circuit logique comprenant une fonction d'auto-test intégrée

(30) Priority: 20.10.1983 JP 196767/83
(43) Date of publication of application: 21.08.1985
(73) Proprietor: KABUSHIKI KAISHA TOSHIBA, Kawasaki-shi, Kanagawa-ken 210 (JP)
(72) Inventor: Mori, Shojiro c/o Patent Division, Minato-ku Tokyo 105 (JP)
(74) Representative: Lehn, Werner, Dipl.-Ing.

(56) References cited:
- SYSTEMS.COMPUTERS.CONTROLS, vol. 7, no. 2, March/April 1976, pages 19-25, Washington, D.C., US; M. YAMAMOTO: "Modification of Reddy's easily testable network and its application to sequential circuits"
- IBM JOURNAL OF RESEARCH AND DEVELOPMENT, vol. 27, no. 3, May 1983, pages 265-272, New York, US; E.B. EICHELBERGER et al.: "Random-pattern coverage enhancement and diagnosis for LSSD logic self-test"
- IBM TECHNICAL DISCLOSURE BULLETIN, vol. 14, no. 10, March 1972, pages 2937,2938, New York, US; A.D. SAVKAR: "N-way testpoint for complex LSI design"

## Description

The present invention relates to an improvement in a logic circuit and, more particularly, to a logic circuit which can easily perform its functional test.

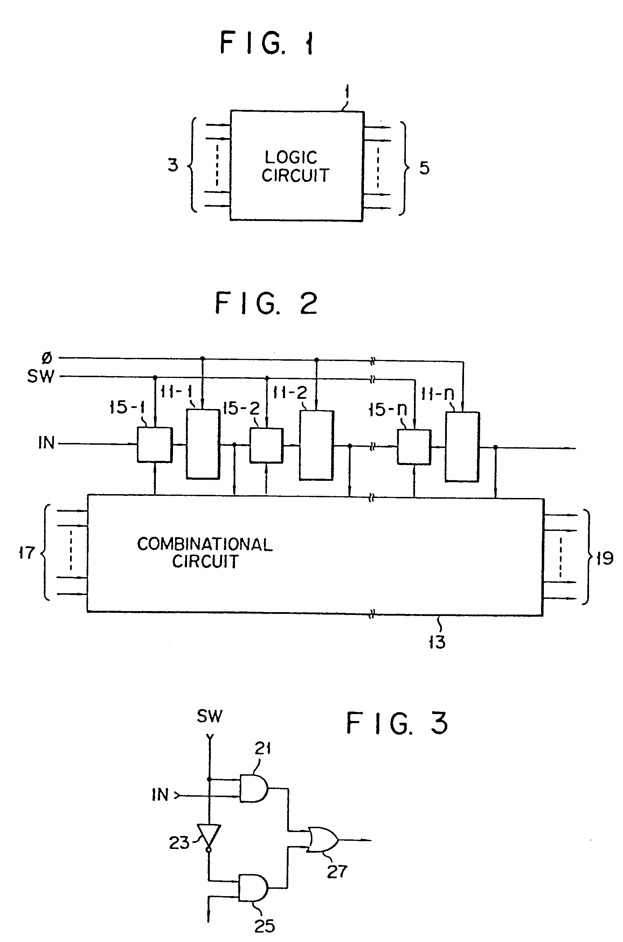

When installing an integrated circuit and the like, the functional test of the integrated circuit and the like are performed. For example, the functional test of a logic circuit 1 shown in Fig. 1 is ordinarily performed in the manner as follows. First, test pattern signals are input from a plurality of input terminals 3 of the logic circuit 1. Next, output signals which are output from a plurality of output terminals 5 are compared with expected values which have been preliminarily prepared. When the comparison results are coincident, it is determined that the logic circuit 1 operates accurately. In the case where the comparison results are not coincident, it is determined that the logic circuit 1 is at fault.

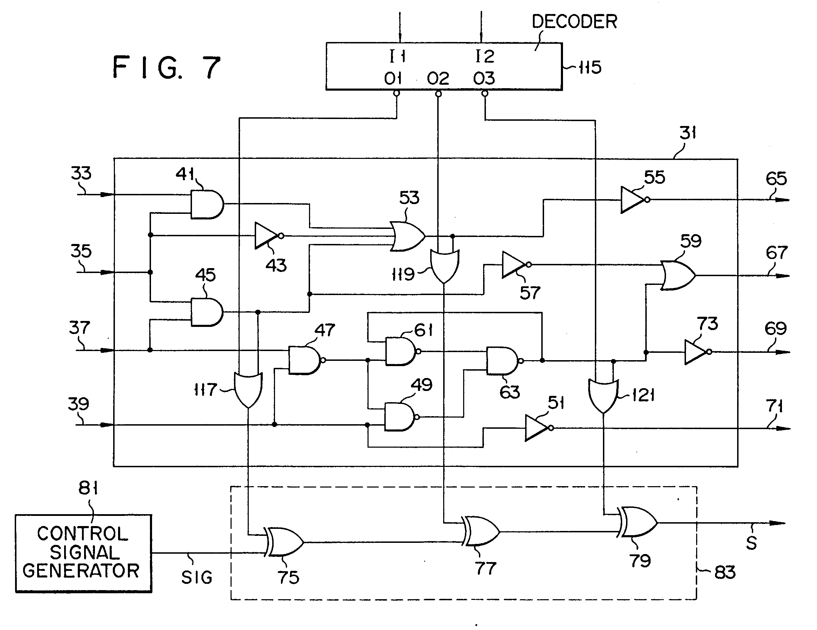

With respect to a sequential circuit among logic circuits, a method of a functional test, so-called scan-path method, is known. Fig. 2 shows one of logic circuits which may be used in the scan-path method. This circuit is a modification of the logic circuit shown in Fig. 7 of U.S. Patent 3,783,254. Generally, sequential circuit can be expressed as a combined form of registers 11-1 to 11-n and a combinational circuit 13. The sequential circuit of Fig. 2 further comprises changeover switches 15-1 to 15-n of the same structure. Fig. 3 shows one of these switches, e.g., the switch 15-1. As shown in this figure, a switch signal SW is supplied to the first input terminal of a 2-input AND gate 21. This signal SW is supplied via an inverter 23 to the first input terminal of a 2-input AND gate 25. A scan input signal IN is supplied to the second input terminal of the AND gate 21. The second input terminal of the AND gate 25 is connected to the combinational circuit 13. The output terminals of the AND gates 21 and 25 are coupled to the first and second input terminals of a 2-input OR gate 27, the output terminal of which is coupled to the register 11-1.

Since the other changeover switches 15-2 to 15-n have the same structure as the switch 15-1, the registers 11-1 to 11-n store the data provided by the combinational circuit 13 as long as the switch signal SW is at the low level. On the other hand, the registers 11-1 to 11-n operate as a shift register when the switch signal SW is at the high level. The scan-path method is performed as follows. Test pattern signals are input from a plurality of input terminals 17 of the combinational circuit 13. Output signals from output terminals 19 are compared with expected values which have been preliminarily prepared. The switch signal SW is switched so that the registers 11-1 to 11-n constitute the shift registers. A pulse signal φ for transference is input to the registers 11-1 to 11-n. The contents of the registers 11-1 to 11-n are shifted in response to the signal φ. The contents of the registers 11-1 to 11-n are sequentially fetched as the output of the register 11-n. The contents of the respective registers 11-1 to 11-n, fetched as the output of the register 11-n, are compared with the expected values which have been preliminarily prepared. The object of a functional test is to check whether a logic circuit works expectedly or not. It is ideal that a small number of input test patterns checks all the possible defects of logic components in a logic circuit. The number of input test patterns depends on how difficult the input signals control each logic node inside a logic circuit and make its logic state (high or low level) to propagate to output terminals. Increase of the number of logic nodes and its complexity increase input test patterns. Increase of the number of output terminals, however, causes the decrease of input test patterns because defects of logic components can be detected more possibly at output terminals.

In the case of the scan-path method, registers play a role of additional output terminals. Since the logic circuit becomes more observable in ths scan-path method than the ordinary method, the number of test patterns of input signals which are input to the input terminals 17 can be reduced as compared with the ordinary method for the functional test described in conjunction with Fig. 1.

According to the ordinary method for the functional test, the number of test patterns of input signals increases, as the constitution of the logic circuit 1 becomes complicated. It raises a problem such that it takes a long time to perform the full function test.

On the other hand, according to the scan-path method, the number of test patterns of input signals can be reduced by using registers as output terminals. However, in this scan-path method, observable points inside a logic circuit are limited on the inputs of the registers 11-1 to 11-n. The signal of each part of the combinational circuit 13 cannot be observed. In addition, when the increase of observable logic nodes is required, it is necessary to add registers to the logic circuit. A register has a larger number of elements which constitute the register function than an ordinary gate circuit or the like. Thus, this method has a drawback such that the scale of the whole circuit becomes large. Further, an increase of the number of the registers 11-1 to 11-n causes the time needed to fetch the contents of these registers 11-1 to 11-n to the outside to increase. Therefore, there is a drawback such that it takes a long time to perform the functional test.

With recent high integration and high density of semiconductor devices, the functional test is becoming more and more significant. With the high integration of semiconductor devices, however, there is a problem such that it takes a longer time to perform the functional test thereof.

The Article in IBM Journal of Research and Development Vol. 27, No. 3, May 1983, pp. 265 - 272 describes the use of linear feedback registers to provide logic component self-test. An additional circuit is provided to observe internal nodes, this circuit including exclusive OR gates. The known device does not provide a facility to test the exclusive OR gate circuit nor is the circuit adaptable to even or odd numbers of errors.
The document "Systems, Computers, Controls", vol. 7, no. 2, 1976, pages 19 to 25: "Modification of Reddy's Easily Testable Network and its Application to Sequential Circuits" from M. Yamamoto discloses a logic circuit having a logic section which includes a plurality of logic elements for receiving at least one input signal performing a predetermined logic operation and outputting at least one signal. A detection circuit is provided comprising an exclusive OR gate circuit for receiving a control signal and a plurality of ouput signals of preselected logic elements of the logic section which are selected to check whether said logic section operates correctly and for outputting a diagnostic signal corresponding to the control signal and the output signals of the preselected logic elements, thereby detecting whether the preselected logic elements produce signals of values determined by the input signals of the logic section and whether said logic section operates correctly. The logic level of control signals is switched in order to distinguish certain error combinations from others. The exclusive OR gate circuit comprises a plurality of exclusive OR gates, each of which has at least first and second input terminals. These OR gates are connected in such a way that the output terminal of each exclusive OR gate is connected to the first input terminal of the succeeding exclusive OR gate and the second input terminals are respectively connected to output terminals of the preselected logic elements.

This invention is made in consideration of the above-mentioned circumstances and the object of the invention is to provide a logic circuit which can easily and accurately perform its functional test in a short time.

The object of the invention is solved by a method for testing a logic circuit having a logic section including a plurality of logic elements for receiving at least one input signal, performing a predetermined logic operation and outputting at least one signal, comprising the steps of: receiving a control signal and a plurality of output signals of preselected logic elements of said logic section which are selected to check whether said logic section operates correctly, said check being performed by a detection circuit comprising an exclusive OR gate circuit; outputting a diagnostic signal from said detection circuit corresponding to the logical combination of the control signal and the output signals of the preselected logic elements, thereby detecting whether the preselected logic elements produce signals of values determined by the input signals of said logic section and whether said logic section operates correctly; generating the control signal and switching the logic level of the control signal to distinguish certain error combinations from others by a control signal generating circuit; wherein said exclusive OR gate circuit comprises a plurality of exclusive OR gates each of which has at least first and second input terminals and which are connected in such a way that the output terminal of each exclusive OR gate is connected to the first input terminal of the succeeding exclusive OR gate and the second input terminals are respectively connected to output terminals of the preselected logic elements and in which the control signal is input to the first input terminal of the front-most exclusive OR gate; inputting a series of test pattern signals to said logic section by an input circuit, **characterized** by inputting a predetermined test pattern signal to said logic section, wherein said preselected logic elements are logic elements whose failures are difficult to check; the logic circuit being tested by performing in sequence: a first step of operating said control signal generating circuit, switching the logic level of the control signal, and checking whether the output of said detection circuit changes; a second step of determining that said detection circuit malfunctions if the output of said detection circuit remains unchanged in said first step and, if so, stopping testing the logic circuit; a third step executed when the output of said detection circuit changes in said first step, of sequentially inputting predetermined test pattern signals to said logic section and checking whether output signals of said logic section and said detection circuit coincide with expected values; and a fourth step of determining that said logic section is operating correctly when the output signals of said logic section and said detection circuit coincide with the expected values and of determining that said logic section malfunctions when the output signals do no coincide with the expected values.

In the logic circuit with such an arrangement, by comparing the output signals of the detection circuit with the expected values, it is possible to check whether the output signals of the preselected logic elements are correct or not. The functional test of the logic section is performed by respectively comparing the output signals of the logic section and the output signals of the detection circuit with the expected values. Therefore, it is possible to remarkably reduce the number of input test pattern signals to the logic section, thereby enabling the functional test of the logic section to be accurately performed in a short time. In addition, the logic elements of which the failures are difficult to discover from the outside can be selected as the above-mentioned preselected logic elements. In such a case, it is possible to remarkably reduce the number of input test pattern signals to the logic section. Thus, it is possible to greatly shorten the time needed to perform the functional test.

This invention can be more fully understood from the following detailed description when taken in conjunction with the accompanying drawings, in which:
Fig. 1 is a block diagram to explain an example of the functional test for a conventional logic circuit;
Fig. 2 is a block diagram to explain an example of the conventional functional test of a sequential circuit;
Fig. 3 is a circuit diagram of one of the changeover switches shown in Fig. 2;
Fig. 4(A) is a circuit diagram showing the concept of the present invention;
Fig. 4(B) is a circuit diagram showing an arrangement of a logic circuit according to one embodiment of the present invention; and
Figs. 5 to 7 are circuit diagrams to explain arrangements of the logic circuits according to other embodiments of the present invention.

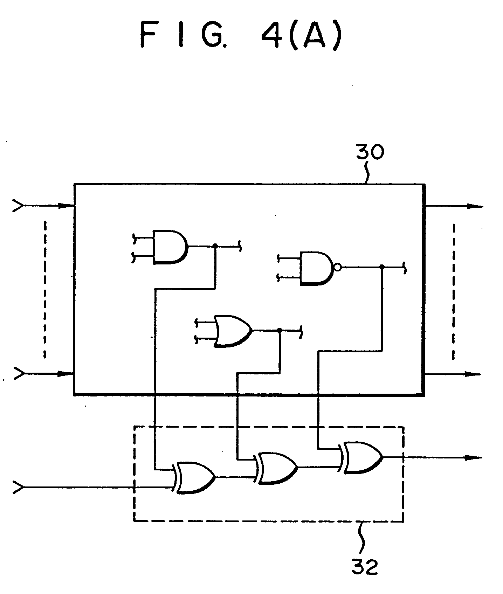

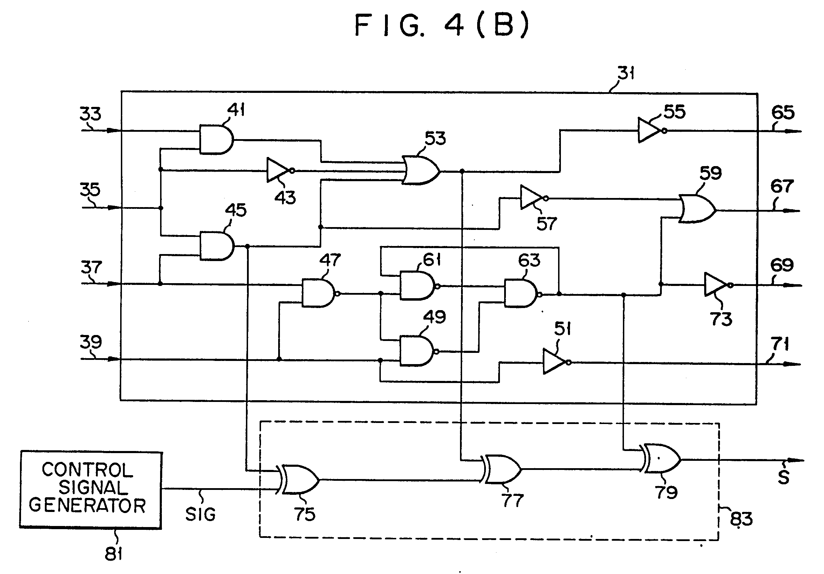

Fig. 4(A) shows the idea of the present invention. As shown in this figure, three EX OR gates 32 are cascade-connected. The input terminals of these gates 32 are coupled to the output terminals of three preselected gates of a logic circuit 30 which comprises other gates of various types.

A logic circuit according to an embodiment of the invention will now be described with reference to Fig. 4(B).

In Fig. 4(B), a logic section 31 is constituted by various kinds of gates and registers, etc., and has a predetermined logic function. Further, it is provided with EX OR gates. The EX OR gates are connected in such a way that the output terminal of each of the EX OR gates is connected to one input terminal of the succeeding EX OR gates. The other input terminals of these EX OR gates are respectively connected to the output terminals of the preselected gates among the gates which constitute the logic section 31. (The preselected gates should be subjected to checking whether the output signals thereof are correct or not.) The more complex the logic section 31, the more effectively the present invention functions. For explanation, it is assumed that the logic section 31 in this embodiment is constituted in the following manner. The logic section 31 has first to fourth input terminals 33, 35, 37 and 39. The first input terminal 33 is connected to a first input terminal of an AND gate 41. The second input terminal 35 is connected to a second input terminal of the AND gate 41, an inverter 43, and a first input terminal of an AND gate 45. The third input terminal 37 is connected to a second input terminal of the AND gate 45 and to a first input terminal of an NAND gate 47. The fourth input terminal 39 is connected to a second input terminal of the NAND gate 47, a second input terminal of the NAND gate 49, and an input terminal of an inverter 51. An output terminal of the AND gate 41, an output terminal of the inverter 43, and an output terminal of the AND gate 45 are connected to first, second and third input terminals of an OR gate 53, respectively. An output terminal of this OR gate 53 is connected to an input terminal of an inverter 55. The output terminal of the AND gate 45 is connected to an input terminal of an inverter 57. An output terminal of the inverter 57 is connected to a first input terminal of an OR gate 59. An output terminal of the NAND gate 47 is connected to a first input terminal of the NAND gate 49 and a second input terminal of an NAND gate 61. Output terminals of the NAND gates 61 and 49 are connected to first and second input terminals of an NAND gate 63, respectively. An output terminal of the NAND gate 63 is connected to a second input terminal of the OR gate 59 and a first input terminal of the NAND gate 61. The inverter 55 is connected to a first output terminal 65 of the logic section 31. An output terminal of the OR gate 59 is connected to a second output terminal 67 of the logic section 31. The output terminal of the NAND gate 63 is connected through an inverter 73 to a third output terminal 69 of the logic section 31. An output terminal of the inverter 51 is connected to a fourth output terminal 71 of the logic section 31. In this embodiment, further a first input terminal of a first EX OR gate 75 is connected to the output terminal of the AND gate 45. An output terminal of the first EX OR gate 75 is connected to a second input terminal of a second EX OR gate 77. A first input terminal of the second EX OR gate 77 is connected to the output terminal of the OR gate 53. Further, an output terminal of the second EX OR gate 77 is connected to a second input terminal of a third EX OR gate 79. A first input terminal of the third EX OR gate 79 is connected to the output terminal of the NAND gate 63. An output terminal of a control signal generator 81 is connected to a second input terminal of the first EX OR gate 75. This control signal generator 81 outputs a control signal SIG at a logic level "0" or "1".

Next, the functional test for the logic circuit with such an arrangement as described above is performed in the manner as follows. Prior to the functional test for the logic section 31, the function of a circuit (hereafter referred to as an EX OR circuit 83) which is constituted by the first, second and third EX OR gates 75, 77 and 79 is tested. First, the logic level of the output signal SIG of the control signal generator 81 is inverted. When the EX OR circuit 83 is not defective, the logic level of an output signal S of the third EX OR gate 79 is inverted. Therefore, when the control signal SIG is inverted, it is possible to discriminate whether the EX OR circuit 83 is at fault or not by checking if the signal S is inverted or not. When the control signal SIG is inverted, if the level of the signal S is inverted, it will be determined that the EX OR circuit 83 is not defective. On the other hand, when the control signal SIG is inverted, if the level of the signal S is not inverted, it will be determined that the EX OR circuit 83 shown in Fig. 4(B) is at fault.

When the EX OR circuit 83 has determined from the above test that it is not at fault, predetermined test pattern signals are then input to the input terminals 33, 35, 37 and 39 of the logic section 31. On the other hand, with these test pattern signals, the signals are used by which the failure of the logic section 31 can be discovered. Those test pattern signals may be the same signals as the conventional ones. The output signals of the first to fourth output terminals 65, 67, 69 and 71 are compared with the expected values. Further, the output signal S of the third EX OR gate 79 is compared with the expected value. By comparing the signal S with the expected value, it is possible to examine the output signals of the AND gate 45, OR gate 53 and NAND gate 63 to see if they are correct or not. Namely, when the constant test pattern signals are input to the logic section 31, the output signals of the logic section 31 are unconditionally determined. In addition, the output signals of the gates 45, 53 and 63 are also unconditionally determined. Thus, the output signal S of the third EX OR circuit 79 is also unconditionally determined. In this case, the control signal SIG been preset to either level of the logic levels "1" and "0". In the case where one of the output signals of the gates 45, 53 and 63 is at the level opposite to the normal level, the output signal S becomes the logic level opposite to the expected value. Therefore, by checking the output signal S, the functional test for the logic section 31 can be also performed. When the output signal S coincides with the expected value and the output signals from the first to fourth output terminals coincide with the expected values, it is determined that this logic section 31 is not at fault. In a similar manner as above, the next test pattern signals are input. Thereafter, the functional test is again conducted on the logic section 31.

When all the output signals of the logic section 31 and the signals S are found equal to the expected values after all the test pattern signals have been input, it is determined at least that the logic section 31 is not faulty.

The method of performing the functional test for the circuit shown in Fig. 4(B) will now be explained below by use of a practical example. First, the voltage of the output signal SIG of the control signal generator 81 is inverted, for example, from logic level "1" to "0". When the signal S is inverted, the EX OR circuit 83 is not defective. The test pattern signals are input to the first to fourth input terminals 33, 35, 37 and 39 of the logic section 31. For explanation, it is assumed that the test pattern signals at the logic levels of "1", "1", "0", and "1" were input to the first to fourth input terminals 33, 35, 37 and 39, respectively. Also, it is assumed that the control signal SIG is at the logic level of "1". At this time, the expected values of the output signals at the first to-fourth output terminals 65, 67, 69 and 71 are logic levels of "0", "1", "0" and "0", respectively. The output signals at the first to fourth output terminals 65, 67, 69 and 71 are compared with the above-mentioned expected values. At this time, the expected values of the output signals of the AND gate 45, OR gate 53 and NAND gate 63 are at logic levels of "0", "1" and "1", respectively. Therefore, the expected value of the output signal S is at logic level of "1". The actual output signals at the first to fourth output terminals 65, 67, 69 and 71 and the actual signal S are compared with the expected values. It is now assumed that, for instance, the AND gate 45 fails and the signal at logic level "1" is output. At this time the output signals at the first to fourth output terminals 65, 67, 69 and 71 coincide with the expected values. Thus, only by comparing the output signals at the first to fourth output terminals 65, 67, 69 and 71 with the expected values, it is impossible to discriminate that the logic section 31 is at fault. On the other hand, the signal at level "1" is input to the first input terminal of the first EX OR gate 75. While, the signals at level "1" are respectively input to the first input terminals of the second and third EX OR gates 77 and 79. The output signal S becomes logic level "0", so that it is different from the expected value. Thus, it is possible to discriminate that the logic section 31 is defective.

In the foregoing embodiment, when the odd number signals are different from the normal (expected) levels, the output signal S is inverted, so that it is detected that a defective portion exists in the logic section 31. On the other hand, when the even number signals are different from the normal levels, the signal S is not inverted, so that the presence of a failed portion in the logic section 31 cannot be detected.

When performing the functional test for the logic section 31, as the number of signals which can be observed on the outside is larger, the number of input test pattern signals can be reduced. In the above embodiment, in addition to the output signals from the first to fourth output terminals 65, 67, 69 and 71, it is also possible to check whether the output signals of the gates which constitute the logic section 31 are correct or not. Thus, this enables the number of input test pattern signals to be reduced compared to the conventional ones. Particularly, if the EX OR circuit 83 is connected to the gates of which the failures are difficult to discover from the outside, the number of input test pattern signals can be remarkably reduced. Consequently, even when the logic circuit has high functions and a complicated circuit arrangement, the functional test thereof can be executed in a short time. On the other hand, when compared with the conventional scan-path method, in the logic circuit according to the foregoing embodiment, it is possible to select only the necessary number of output signals of the arbitrary gates and to examine them. Also, these signals can be checked through the EX OR circuit 83 in a short time. Therefore, it is possible to realize the remarkable reduction of the time period to perform the functional test even when compared to the above-mentioned scan-path method.

The logic section 31 and EX OR circuit 83 may be formed on one semiconductor chip.

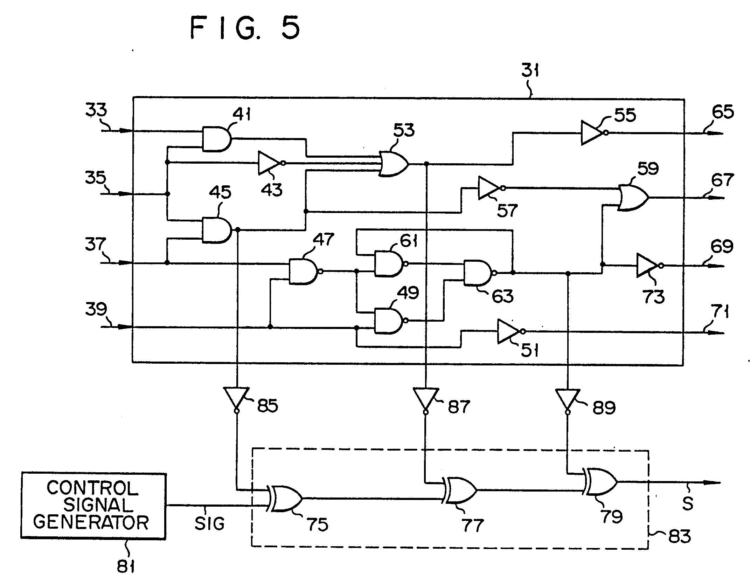

Fig. 5 shows a modification of the logic circuit shown in Fig. 4(B). As shown in Fig. 5, an inverter 85 has its input terminal connected to the output terminal of an AND gate 45, and its output terminal coupled to the first input terminal of a first EX OR gate 75. An inverter 87 has its input terminal coupled to the output terminal of an OR gate 53, and its output terminal connected to the first input terminal of a second EX OR gate 77. An inverter 89 has its input terminal connected to the output terminal of a NAND gate 63 and its output terminal coupled to the first input terminal of a third EX OR gate 79. The expected value of the output signal S of the third EX OR gate 79 is the inversion of the expected value of the signal S generated by the circuit of Fig. 4(B).

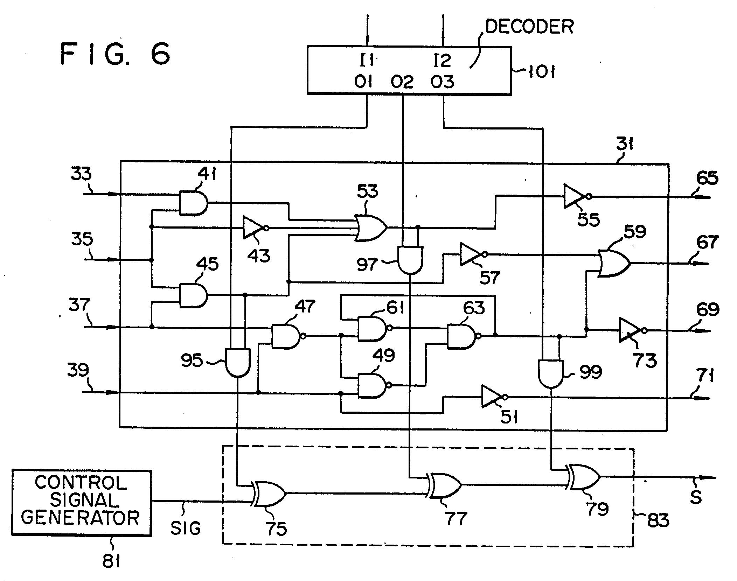

Fig. 6 is a circuit diagram showing an arrangement of a logic circuit according to another embodiment of the present invention. In addition, in Fig. 6, the parts and elements corresponding to those shown in Fig. 4(B) are designated by the same reference numerals and their descriptions will be omitted. A feature of the circuit shown in Fig. 6 is that first to third AND gates 95, 97 and 99 and a decoder 101 are provided. In Fig. 6, a first input terminal of a first AND gate 95 is connected to the output terminal of an AND gate 45. A second input terminal of the first AND gate 95 is connected to a first output terminal O1 of a decoder 101. Further, an output terminal of the first AND gate 95 is connected to the first input terminal of a first EX OR gate 75. A first input terminal of the second AND gate 97 is connected to the output terminal of an OR gate 53. A second input terminal of the second AND gate 97 is connected to a second output terminal O2 of the decoder 101. An output terminal of the second AND gate 97 is connected to the first input terminal of a second EX OR gate 77. A first input terminal of the third AND gate 99 is connected to the output terminal of a NAND gate 63. A second input terminal of the third AND gate 99 is connected to a third output terminal O3 of the decoder 101. The output terminal of the third AND gate 99 is connected to the first input terminal of a third EX OR gate 79. For example, a selection signal of two bits is input to the input terminals I1, I2 of the decoder 101. A signal at logic level "1" is output from one of the three output terminals O1 to O3 in response to this 2-bit selection signal, while signals at logic level "0" are output from the other two output terminals.

A method of performing the functional test for the logic circuit shown in Fig. 6 will now be explained.

The operation of an EX OR circuit 83 is examined by use of a similar method as in the case of the circuit shown in Fig. 4(B). Next, the test pattern signals are input to the first to fourth input terminals 33, 35, 37 and 39. The output signals from first to fourth output terminals 65, 67, 69 and 71 are compared with the expected values. Then, the above-mentioned selection signal is input to the input terminals I1, I2 of the decoder 101, thereby a signal at logic level "1" is output from the first output terminal O1. This makes the first AND gate 95 open. The output signal of the AND gate 45 is input through the first AND gate 95 to the first input terminal of the first EX OR gate 75. At this time, the second and third AND gates 97 and 99 output the signals at logic level "0". The signal S is compared with the expected value. When the signal S is equal to the expected value, the output signal of the AND gate 45 is determined to be correct. On the other hand, when the signal S is different from the expected value, the output signal of the AND gate 45 is not correct, so that the logic section 31 is determined to be defective. Next, the selection signal is switched and, for instance, the signal at logic level "1" is output from the second output terminal O2. The output signal of the OR gate 53 is input through the second AND gate 97 to the first input terminal of the second EX OR gate 77. The signal S is compared with the expected value. Similarly, the selection signal is switched to examine whether the output signal of the NAND gate 63 is correct or not. In the circuit shown in Fig. 6, the output signals of the AND gate 45, OR gate 53 and NAND gate 63 are checked to see if they are normal or not, respectively. Therefore, even if the even number signals (e.g., two) are simultaneously different from the correct levels, it is possible to discriminate that the logic section 31 is at fault. Further, an approximate defective portion in the logic section 31 can be checked.

In case of this embodiment, it is necessary to check the output signals of the gates 45, 53 and 63 to see if they are correct or not by changing the setting of the selection signal which is input to the decoder 101. Therefore, it takes a slightly longer time for the functional test than that of Fig. 4(B); however, the invention is extremely effective for a logic circuit having a large probability of failure occurrence.

In the foregoing embodiment, the output signals of the gates 45, 53 and 63 are independently examined in accordance with the output of the decoder 101. The invention is extremely effective when the number of signals needed to be checked in the logic section 31 is large. In addition, in the embodiments shown in Figs. 4(B), 5 and 6, the output signals of the three gates 45, 53 and 63 were checked. However, the invention is not limited to this. Two, four, or more signals in the logic section 31 may be checked to see if they are correctly output or not. The number of signals checked may be an arbitrary number. Also, as the signals for examination, the signals of which the abnormality is difficult to discover from the outside (through the output signals of the logic section 31) are selected. The number of EX OR gates constituting the EX OR circuit 83 is also increased or decreased in association with the increase or decrease in the number of signals examined.

Fig. 7 shows a modification of the circuit shown in Fig. 6. The decoder 101 of the circuit of Fig. 6 is so designed as to output a signal of logic level "1" from one of the output terminals and signal of logic level "0" from the remaining two output terminals. Which output terminal supplies a "1" level signal is determined by the selection signal supplied to the decoder 101. On the other hand, the circuit of Fig. 7 has a decoder 115 which is so designed as to output a signal of logic level "0" from one of the output terminals O1 to O3 and signals of logic level "1" from the remaining two output terminals. Which output terminal suplies a "0" level signal is determined by the selection signal supplied to the deocer 115. In this circuit, OR gates 117, 119 and 121 are used in place of the AND gates 95, 97 and 99 (Fig. 6). The signal from the terminal O1 is supplied to one input terminal of the a 2-input OR gate 117. The signal from the terminal O2 is supplied to one input terminal of a 2-input OR gate 119. The output signal from the terminal O3 is supplied to one input terminal of a 2-input OR gate 121. The expected value of the signal S produced by the circuit of Fig. 7 is the inversion of the expected value of the signal S output by the circuit of Fig. 6.

Of course, in the circuits of Figs. 4(B), 5, 6 and 8, the EX OR gates 75, 77 and 79 may be replaced by a circuit which performs the same exclusive OR operation.

In the logic circuits shown in Figs. 4(B) - 7, one example has been shown for explaining as the arrangement of each logic section 31; the invention is not limited to this. In addition, the signals which are checked are not limited to the above-mentioned signals. This invention can be applied to logic circuits having a logic section with any arrangement. The examined signals are arbitrarily selected. In particular, the signals of which the abnormality is difficult to discover from the outside can be checked by this method. Further, the number of signals examined can be an arbitrary number. Therefore, according to the present invention, even when the logic circuit has high functions and a complicated circuit arrangement, the number of input test pattern signals can be reduced and the functional test thereof can be accurately performed in a short time.

## Claims

1. A method for testing a logic circuit having a logic section (31) including a plurality of logic elements for receiving at least one input signal, performing a predetermined logic operation and outputting at least one signal, comprising the steps of:
receiving a control signal (SIG) and a plurality of output signals of preselected logic elements (45,53,63) of said logic section (31) which are selected to check whether said logic section operates correctly, said check being performed by a detection circuit comprising an exclusive OR gate circuit (83);
outputting a diagnostic signal from said detection circuit (83) corresponding to the logical combination of the control signal (SIG) and the output signals of the preselected logic elements (45,53,63), thereby detecting whether the preselected logic elements (45,53,63) produce signals of values determined by the input signals of said logic section (31) and whether said logic section (31) operates correctly;
generating the control signal and switching the logic level of the control signal to distinguish certain error combinations from others by a control signal generating circuit (81);
wherein said exclusive OR gate circuit (83) comprises a plurality of exclusive OR gates (75,77,79) each of which has at least first and second input terminals and which are connected in such a way that the output terminal of each exclusive OR gate (75,77) is connected to the first input terminal of the succeeding exclusive OR gate (77,79) and the second input terminals are respectively connected to output terminals of the preselected logic elements (45,53,63) and in which the control signal (SIG) is input to the first input terminal of the front-most exclusive OR gate (75);
inputting a series of test pattern signals to said logic section (31) by an input circuit,
**characterized** by
inputting a predetermined test pattern signal to said logic section (31), wherein said preselected logic elements (45,53,63) are logic elements whose failures are difficult to check;
the logic circuit being tested by performing in sequence:
a first step of operating said control signal generating circuit (81), switching the logic level of the control signal (SIG), and checking whether the output of said detection circuit changes;
a second step of determining that said detection circuit malfunctions if the output of said detection circuit remains unchanged in said first step and, if so, stopping testing the logic circuit;
a third step executed when the output of said detection circuit changes in said first step, of sequentially inputting predetermined test pattern signals to said logic section (31) and checking whether output signals of said logic section (31) and said detection circuit (83) coincide with expected values; and
a fourth step of determining that said logic section (31) is operating correctly when the output signals of said logic section (31) and said detection circuit (83) coincide with the expected values and of determining that said logic section (31) malfunctions when the output signals do not coincide with the expected values.

## Patentansprüche

1. Ein Verfahren zum Testen eines Logikschaltkreises mit einem Logikabschnitt (31) mit einer Vielzahl von Logikelementen zum Empfangen von zumindest einem Eingangssignal, welcher eine vorbestimmte Logikoperation durchführt und zumindest ein Signal ausgibt, wobei das Verfahren folgende Schritte umfaßt:
Empfangen eines Steuersignals (SIG) und einer Vielzahl von Ausgangssignalen vorbestimmter Logikelemente (45, 53, 63) des Logikabschnitts (31), welche ausgewählt werden, um zu prüfen, ob der Logikabschnitt korrekt funktioniert, wobei die Prüfung durchgeführt wird durch einen Erfassungsschaltkreis mit einem ausschließlichen ODER-Gate-Schaltkreis (83);
Ausgeben eines Diagnosesignals von dem Erfassungsschaltkreis (83), entsprechend der logischen Kombination des Steuersignals (SIG) und der Ausgangssignale der vorbestimmten Logikelemente (45, 53, 63), um dadurch zu erfassen, ob die vorbestimmten Logikelemente (45, 53, 63) Signale mit Werten erzeugen, wie bestimmt durch die Eingangssignale des Logikabschnitts (31), und ob der Logikabschnitt (31) korrekt funktioniert;
Erzeugen des Steuersignals und Schalten des logischen Pegels des Steuersignals, um bestimmte Fehlerkombinationen von anderen zu unterscheiden, durch einen Steuersignal-Erzeugungsschaltkreis (81);
wobei der ausschließliche ODER-Gate-Schaltkreis (83) eine Vielzahl ausschließlicher ODER-Gates (75, 77, 79) umfaßt, von denen jedes zumindest einen ersten und zweiten Eingangsanschluß hat und welche so verbunden sind, daß der Ausgangsanschluß jedes ausschließlichen ODER-Gates (75, 77) verbunden ist mit dem ersten Eingangsanschluß des folgenden ausschließlichen ODER-Gates (75, 79) und der zweite Eingangsanschluß jeweils verbunden ist mit einem Ausgangsanschluß der vorbestimmten Logikelemente (45, 53, 63) und wobei das Steuersignal (SIG) eingegeben wird an den ersten Eingangsanschluß des vordersten ausschließlichen ODER-Gates (75);
Eingeben einer Reihe von Testmustersignalen an den Logikabschnitt (31) durch einen Eingangsschaltkreis,
gekennzeichnet durch
Eingeben eines vorbestimmten Testmustersignals an den Logikabschnitt (31),
wobei die vorbestimmten Logikelemente (45, 53, 63) Logikelemente sind, deren Ausfälle schwer zu prüfen sind; wobei der Logikschaltkreis getestet wird durch sequentielles Durchführen der Schritte:
einen ersten Schritt des Betreibens des Steuersignal-Erzeugungsschaltkreises (81), Schalten des logischen Pegels des Steuersignals (SIG) und Prüfen, ob die Ausgabe des Erfassungsschaltkreises sich ändert;
einen zweiten Schritt des Bestimmens, daß der Erfassungsschaltkreis nicht funkioniert, wenn die Ausgabe des Erfassungsschaltkreises ungeändert bleibt im ersten Schritt und falls dem so ist, Stoppen des Logikschaltkreises;
einen dritten Schritt, der ausgeführt wird, wenn die Ausgabe des Erfassungsschaltkreises sich beim ersten Schritt ändert, des sequentiellen Eingebens vorbestimmter Testmustersignale an den Logikabschnitt (31) und Prüfen, ob Ausgangssignale des Logikabschnitts (31) und des Erfassungsschaltkreises (83) mit erwarteten Werten übereinstimmen; und
einen vierten Schritt des Bestimmens, daß der Logikabschnitt (31) korrekt funktioniert, wenn die Ausgangssignale des Logikabschnitts (31) und des Erfassungsschaltkreises (83) mit den erwarteten Werten übereinstimmen, und des Bestimmens, daß der Logikabschnitt (31) nicht funktioniert, wenn die Ausgangssignale nicht mit den erwarteten Werten übereinstimmen.

## Revendications

1. Procédé pour tester un circuit logique comportant une unité logique (31) incluant une pluralité d'éléments logiques pour recevoir au moins un signal d'entrée, exécuter une opération logique prédéterminée et sortir au moins un signal, comprenant les étapes qui consistent à:
recevoir un signal de commande (SIG) et une pluralité de signaux de sortie d'éléments logiques prédéterminés (45,53,63) de ladite unité logique (31) qui sont sélectionnés pour contrôler si ladite unité logique fonctionne correctement, ledit contrôle étant effectué au moyen d'un circuit de détection comprenant un circuit à portes OU-exclusif (83);
sortir un signal de diagnostic dudit circuit de détection (83) correspondant à la combinaison logique du signal de commande (SIG) et des signaux de sortie des éléments logiques présélectionnés (45,53,63), pour détecter par celui-ci si les éléments logiques présélectionnés (45,53,63) produisent des signaux de valeurs déterminées par les signaux d'entrée de ladite unité logique (31) et si ladite unité logique (31) fonctionne correctement;
générer le signal de commande et commuter le niveau logique du signal de commande pour distinguer certaines combinaisons erronées parmi d'autres par un circuit générateur de signaux de commande (81);
dans lequel ledit circuit à portes OU-exclusif (83) comprend une pluralité de portes OU-exclusif (75,77,79) dont chacune comporte au moins des première et seconde bornes d'entrée et qui sont connectées de telle manière que la borne de sortie de chaque porte OU-exclusif (75,77) est connectée à la première borne d'entrée de la porte OU-exclusif suivante (77,79) et les secondes bornes d'entrée sont respectivement connectées aux bornes de sortie des éléments logiques présélectionnés (45,53,63) et dans lequel le signal de commande (SIG) est entré par la première borne d'entrée de la porte OU-exclusif la plus en avant (75);
entrer une série de signaux de configurations de test dans ladite unité logique (31) par un circuit d'entrée,
caractérisé en ce qu'il consiste à
entrer un signal de configuration de test prédéterminé dans ladite unité logique (31), dans laquelle lesdits éléments logiques présélectionnés (45,53,63) sont des éléments logiques dont les défaillances sont difficiles à contrôler;
le circuit logique étant testé en exécutant en séquence:
une première étape de fonctionnement dudit circuit générateur de signaux de commande (81), de commutation du niveau logique du signal de commande (SIG), et de contrôle si le signal de sortie dudit circuit de détection change;
une deuxième étape de détermination que ledit circuit de détection fonctionne mal si le signal de sortie dudit circuit de détection reste inchangé dans ladite première étape et, s'il en est ainsi, d'arrêt du test du circuit logique;
une troisième étape,exécutée quand le signal de sortie dudit circuit de détection change dans ladite première étape, d'entrée séquentielle de signaux de configurations de test prédéterminés dans ladite unité logique (31) et de contrôle si les signaux de sortie de ladite unité logique (31) et dudit circuit de détection (83) coïncident avec des valeurs prévues; et
une quatrième étape de détermination que ladite unité logique (31) fonctionne correctement quand les signaux de sortie de ladite unité logique (31) et dudit circuit de détection (83) coïncident avec les valeurs prévues et de détermination que ladite unité logique (31) fonctionne mal quand les signaux de sortie ne coïncident pas avec les valeurs prévues.
